(19) **Europäisches Patentamt**

**European Patent Office**

**Office européen des brevets**

(11) **EP 0 650 258 B1**

(12) **EUROPÄISCHE PATENTSCHRIFT**

(45) Veröffentlichungstag und Bekanntmachung des Hinweises auf die Patenterteilung:
**06.09.2000 Patentblatt 2000/36**

(51) Int. Cl.[7]: **H03K 17/30**, G01R 19/165, H03F 1/30, H03K 19/003

(21) Anmeldenummer: **94115730.7**

(22) Anmeldetag: **06.10.1994**

(54) **Treiberschaltung zur Erzeugung einer Schaltspannung**

Driver circuit for producing a switching voltage

Circuit d'attaque servant à produire une tension de commutation

(84) Benannte Vertragsstaaten:
**DE ES FR GB IT NL SE**

(30) Priorität: **20.10.1993 DE 4335684**

(43) Veröffentlichungstag der Anmeldung:
**26.04.1995 Patentblatt 1995/17**

(73) Patentinhaber:
**DaimlerChrysler Aerospace Aktiengesellschaft
81663 München (DE)**

(72) Erfinder:
• **Ludwig, Michael, Dipl.-Ing.
D-89077 Ulm (DE)**

• **Reber, Rolf, Dipl.-Ing.
D-89073 Ulm (DE)**
• **Feldle, Heinz-Peter, Dr.-Ing.
D-89250 Senden (DE)**

(74) Vertreter: **Straub, Bernd
DaimlerChrysler AG,
Intellectual Property Managament
Sedanstr. 10 / Geb. 17
89077 Ulm (DE)**

(56) Entgegenhaltungen:
**EP-A- 0 291 191        FR-A- 2 680 291
US-A- 4 897 613**

**Beschreibung**

Die Erfindung geht aus von einer Treiberschaltung zur Erzeugung einer Schaltspannung nach dem Oberbegriff des Patentanspruchs 1.

In vielen Anwendungsbereichen der Elektronik, insbesondere der Halbleiter-Schaltungstechnologie, ist es erforderlich, ein in analoger Form vorliegendes Eingangssignal mit Hilfe einer Schaltschwelle in ein in digitaler Technik weiterverarbeitbares Ausgangssignal (Schaltsignal) umzuwandeln. Dieses ist abhängig von der gewählten Technik, z.B. der sogenannten TTL-Technik. Die entsprechenden Schaltpunkte sind für jede Art derartiger Digital-Technik vorgegeben. Viele Treiberschaltungen basieren auf einem Halbleiter-Verstärker mit einer hohen Verstärkung, so daß dessen Ausgangssignal lediglich zwei stabile Schaltzustände besitzt. Ein solcher Treiber wird z.B. auch Komparator genannt. Solche Treiber sollen möglichst stabile Schaltparameter besitzen, z.B. eine möglichst vernachlässigbare Temperaturdrift der Schaltschwelle sowie der Schaltzustände.

Halbleiterbauelemente für die Hoch- und/oder Höchstfrequenztechnologie, z.B. die sogenannte Millimeterwellentechnologie, basieren auf dem Halbleitermaterial GaAs (GaAs-Technologie). Damit sind sogenannte HEMT-Bauelemente ("high electron mobility technologie") herstellbar. Derartige HEMT-Bauelemente besitzen ein an sich stabiles Temperaturverhalten, das heißt eine geringe Temperaturdrift der elektrischen Eigenschaften.

Aus der US-A-4 897 613 ist eine temperaturkompensierte Treiberschaltung bekannt zur Erzeugung von Schaltsignalen, die in der sogenannten ECL-Technologie benötigt werden. Die Treiberschaltung enthält einen Halbleiterverstärker, der ein Eingangssignal in ein der ECL-Technologie entsprechendes Ausgangssignal umwandelt. Dessen zugehörige Ausgangsspannung wird durch eine Temperaturkompensierungsschaltung so geregelt, daß Temperaturschwankungen keinen ungewünschten Einfluß haben. Die Temperaturkompensierungsschaltung basiert dabei auf einer Messung der temperaturabhängigen Spannung über mehrere in Serie geschaltete Dioden.

Der Erfindung liegt die Aufgabe zugrunde, eine gattungsgemäße Treiberschaltung anzugeben, die eine geringe Temperaturdrift besitzt und die in kostengünstiger Weise insbesondere in mit GaAs-Technologie hergestellte Bauelemente integrierbar ist.

Diese Aufgabe wird gelöst durch die im kennzeichnenden Teil des Patentanspruchs 1 angegebenen Merkmale. Vorteilhafte Ausgestaltungen und/oder Weiterbildungen sind den weiteren Ansprüchen entnehmbar.

Ein erster Vorteil der Erfindung besteht darin, daß das Ausgangssignal nahezu unabhängig ist von dem Herstellungsprozeß der Feldeffekt-Transistoren.

Ein zweiter Vorteil besteht darin, daß nur ein einziger Typ von Feldeffekt-Transistoren notwendig ist, z.B. n-Kanal Sperrschicht-Feldeffekt-Transistoren.

Ein dritter Vorteil besteht darin, daß das Ausgangssignal nahezu unabhängig ist von Temperaturschwankungen beim Betrieb der Schaltung.

Ein vierter Vorteil besteht darin, daß zusätzlich zu den Feldeffekt-Transistoren lediglich ohmsche Widerstände benötigt werden, welche in kostengünstiger Weise in integrierter Technologie herstellbar sind.

Ein fünfter Vorteil besteht darin, daß die Schaltungsanordnung in zuverlässiger und kostengünstiger Weise in mit GaAs-Technologie hergestellte integrierte Schaltungen integrierbar ist.

Ein sechster Vorteil besteht darin, daß auch bei der Erweiterung der Grundschaltung durch einen Inverter und/oder einen Pegelwandler lediglich eine einzige Spannungsquelle benötigt wird.

Weitere Vorteile ergeben sich aus der nachfolgenden Beschreibung:
Die Erfindung wird im folgenden anhand von Ausführungsbeispielen näher erläutert unter Bezugnahme auf schematisch dargestellte Figuren. Es zeigen

FIG. 1    ein erstes Ausführungsbeispiel zur Erläuterung der Erfindung;

FIG. 2    ein der FIG. 1 entsprechendes Beispiel, bei dem jedoch zusätzlich eine Inverterschaltung für das Ausgangssignal vorhanden ist;

FIG. 3    ein der FIG. 2 entsprechendes Beispiel, bei dem jedoch zusätzlich ein Pegelwandler für das Eingangssignal vorhanden ist.

Im folgenden wird der beispielhaft verwendete Sperrschicht-Feldeffekt-Transistor durch JFET abgekürzt. Diese Abkürzung ist einem Fachmann geläufig.

Die im folgenden beschriebenen Beispiele beruhen auf der Verwendung von n-Kanal-JFETs. Einem Fachmann ist es jedoch geläufig, eine entsprechende Schaltung mit beliebigen anderen selbstleitenden FETs aufzubauen, so daß die Erfindung auch diese umfaßt.

Bei den folgenden Beispielen werden vorteilhafterweise lediglich festeingestellte ohmsche Widerstände verwendet, obwohl die JFETs, die im allgemeinen als MESFETs ausgebildet sind, in ihren elektrischen Grundeigenschaften erheblich schwanken können. Dieses ist insbesondere bei der GaAs-Technologie der Fall. Ein nachträglicher Abgleich der Widerstände ist nicht erforderlich.

Die Erfindung beruht auf der Erkenntnis, eine die JFETs kennzeichnende Grund-Eigenschaft, nämlich die aktuelle Abschnürspannung $U_p$, zu messen und davon abhängige Spannungen abzuleiten. Diese werden weiteren JFETs zugeführt und damit deren Arbeitspunkte und/oder Arbeitsbereiche eingestellt. Damit sind herstellungsbedingt Toleranzen in einem weiten Bereich, z.B. über ± 20 %, ausgleichbar.

Die folgenden Beispiele beziehen sich auf die Erzeugung eines Ausgangssignales, das, in Abhängigkeit von dem Pegel des Eingangssignals, lediglich die Schaltzustände 0V (Masse-Potential) und -3,5 V annehmen kann. Diese Schaltspannungen werden insbesondere für Hoch- und/oder Höchstfrequenzschaltungen, z.B. in der Millimeterwellentechnik, benötigt. Diese verwendet in monolithisch- oder hybridintegrierter Form die GaAs-Technologie.

Die folgenden Beispiele beziehen sich auf einen EinheitsJFET, der eine nominelle Abschnürspannung $U_p$ = 1,2 V und einen nominellen Sättigungsstrom $I_{dss}$ = 1,45 mA besitzt. Die zugehörigen aktuellen Werte können um ± 20 % schwanken, das heißt, -1,4 V < $U_p$ < -1 V; 1,2 mA < $I_{dss}$ < 1,7 mA. Es wird eine negative Spannungsquelle SP von -7 V zugrunde gelegt.

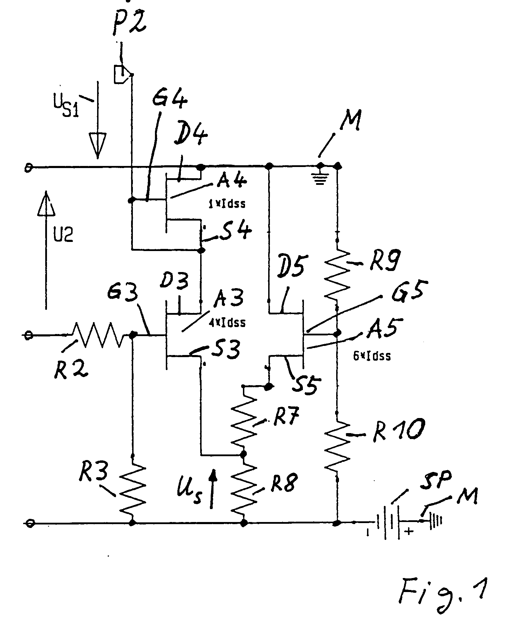

Gemäß FIG. 1 erfolgt die Messung der aktuellen Abschnürspannung mit dem dritten JFET A5, der als Source-Folger geschaltet ist und der einen nominell hohen Sättigungstrom, z.B. $6xI_{dss}$, besitzt. Mit dem zugehörigen Gate-Spannungsteiler R9, R10, z.B. R9 = 2600 Ω, R10 = 1400 Ω, wird an Gate G5 eine feste Referenzspannung eingestellt. Infolge des hohen Sättigungstroms des Transistors A5 entsteht an der Reihenschaltung der Widerstände R7 und R8 eine Spannung, die näherungsweise aus der Differenz der Referenzspannung und der Abschnürspannung besteht. Da diese Spannung über den Spannungsteiler R7, R8, z.B. R7 = 50 Ω und R8 = 600 Ω die Sourceelektrode des JFETs A3 steuert, wird der Arbeitspunkt dieses Transistors stabilisiert, da er dieselbe Abschnürspannung wie der Transistor A5 besitzt.

Die eigentliche Ableitung eines Ausgangssignales $U_{s1}$, das an dem Anschluß P2 abgreifbar ist, aus dem Eingangssignal U2, das z.B. zwischen den Werten -7 V und 0 V schwanken kann, erfolgt mit dem ersten JFET A3. Dabei wird das Eingangssignal U2 mit Hilfe eines Spannungsteiler R2, R3, z.B. R2 = 10 kΩ, R3 = 30 kΩ, an das Gate G3 gelegt. Source S3 liegt an dem erwähnten Source-Spannungsteiler R7, R8, so daß an Source S3 eine Source-Spannung $U_s$, z.B. $U_s \approx$ -4V, anliegt, die proportional der aktuellen Abschnürspannung ist und damit den Arbeitsbereich des ersten JFETs A3 einstellt und stabilisiert. Dieser besitzt ebenfalls einen hohen Sättigungsstrom, z.B. $4xI_{dss}$. Das Ausgangssignal $U_{s1}$ ist abgreifbar an dem Anschluß P2 sowie dem damit verbundenen Drain D3. Zwischen diesem und Masse M (ein Pol der Spannungsquelle) liegt der zweite JFET A4, der den Einheits-Sättigungsstrom $1xI_{dss}$ besitzt und bei dem Drain D4 an Masse M liegt und Gate G4 mit Source S4 verbunden sind und an Drain D3 (erster JFET A3) liegen.

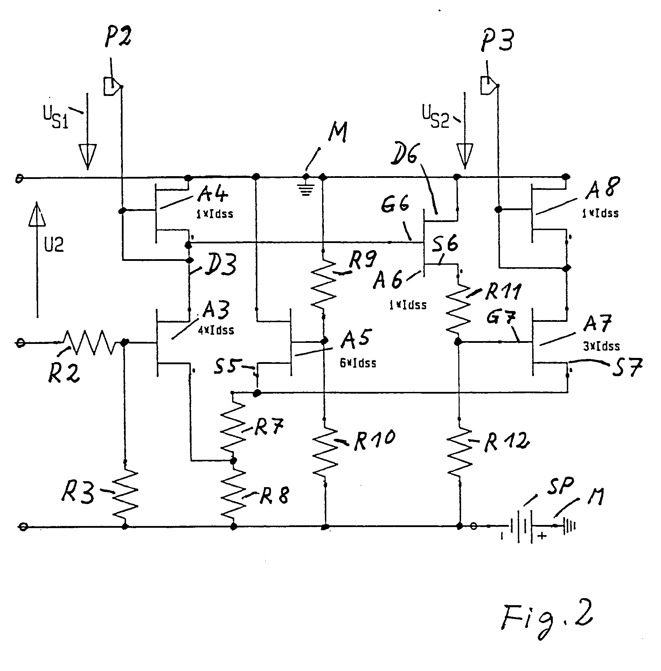

Das Ausführungsbeispiel entsprechend FIG. 2 unterscheidet sich von dem beschriebenen (FIG. 1) lediglich dadurch, daß zusätzlich eine Inverterstufe, bestehend aus den JFETs A6 bis A8 sowie den Widerständen R11, R12, vorhanden ist. An dem Ausgang P3 ist ein zu dem Ausgangssignal $U_{s1}$ (an P2) inverses Ausgangssignal $U_{s2}$ abgreifbar.

Die Inverterstufe enthält eine Source-Folger-Schaltung, bestehend aus dem JFET A6, dessen Gate G6 mit Drain D3 (JFET A3) verbunden ist, dessen Drain D6 an Masse M liegt und dessen Source S6 über den Spannungsteiler R11, R12, z.B. R11 = 3 kΩ, R12 = 2,2 kΩ an den anderen Pol (-) der Spannungsquelle SP liegt. JFET A6 ist für den Einheits-Sättigungsstrom ($1xI_{dss}$) ausgelegt. Die Schaltungsanordnung des JFET A7 ($3xI_{dss}$) und des JFET A8 ($1xI_{dss}$) entspricht derjenigen der JFETs A3, A4. Die Umkehrung des Ausgangssignals $U_{s1}$ erfolgt dabei in dem JFET A7, dessen Gate G7 mit dem Spannungsteiler R11, R12 verbunden ist und dessen Source S7 an Source S5 des JFET's A5 liegt. Dadurch wird erreicht, daß die von JFET A5 gemessene aktuelle Abschnürspannung auch die Inverterstufe A6 bis A8 bezüglich des Arbeitsbereiches optimal einstellt.

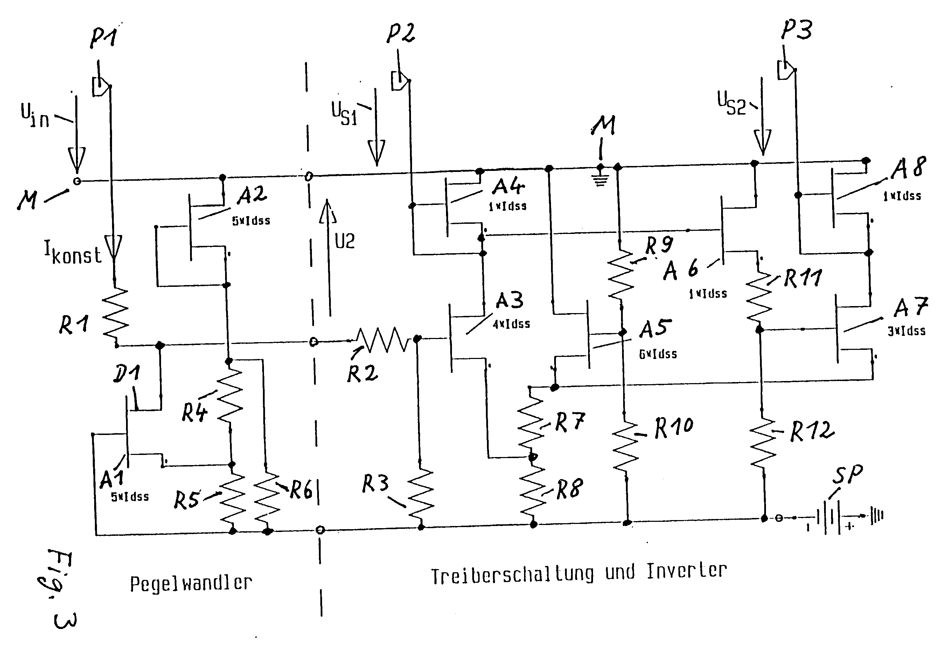

Das Ausführungsbeispiel entsprechend FIG. 3 unterscheidet sich von demjenigen der FIG. 2 dadurch, daß ein zusätzlicher Pegelwandler vorhanden ist. Dieser ermöglicht, daß ein in weiten Grenzen beliebiges Eingangssignal $U_{in}$, das zwischen dem Anschluß P1 und Masse M anliegt, in die negativen Schalt-Ausgangssignale $U_{s1}$ (an P2) bzw. $U_{s2}$ (an P3) umgewandelt wird. Dabei kann das Eingangssignal $U_{in}$ schwanken, z.B. zwischen den Spannungen +5 V und 0 V, so daß z.B. sogenannte TTL-Signale, welche zwischen +2,4 V und 0,7 V schwanken, umgewandelt werden können.

Der Pegelwandler enthält als wesentlichen Schaltungsteil eine Konstantstromquelle, die in der am gleichen Tag angemeldeten deutschen Patentanmeldung P 4335683.4 (internes Aktenzeichen: UL 93/39a) näher beschrieben ist. Die Konstantstromquelle besteht aus den JFETs A1, A2 sowie den ohmschen Widerständen R4 bis R6, wobei der Konstantstrom $I_{konst}$ im wesentlichen durch Drain D1 (JFET A1) fließt.

Dieser Konstantstrom $I_{konst}$, z.B. $I_{konst}$ = 1 mA, fließt auch durch den Eingangswiderstand R1, z.B. R1 = 7,7 kΩ, der zwischen Drain D1 und dem (Eingangs-)Anschluß P1 geschaltet ist. Drain D1 ist andererseits mit dem Eingang (R2) der Treiberschaltung verbunden. Die dort anliegende (Treiber-)Eingangsspannung U2 ergibt sich aus dem ohmschen Gesetz gemäß der Formel:

$$U2 = U_{in} - R1 \cdot I_{konst} .$$

Ist nun $U_{in}$ eine positive Spannung und gilt außerdem die Formel:

$$R1 \cdot I_{konst} > \hat{U}_{in} ,$$

wobei $\hat{U}_{in}$ die maximal zulässige positive Eingangsspannung bedeutet, so ist die (Treiber-)Eingangsspannung U2 immer eine negative Spannung, die vorzugsweise in einem Bereich von -3,5 V bis -5,5 V liegt. Diese wird über den erwähnten (Eingangs-)Spannungsteiler R2, R3, z.B. R2 = 10 kΩ, R3 = 30 kΩ, weiter in den negativen Spannungsbereich verschoben, wobei gleichzeitig eine Amplitudenabschwächung erfolgt, und in der beschriebenen Weise weiterverarbeitet.

Werden nun alle JFETs gemäß FIG. 3, mit den dort angegebenen Sättigungsströmen, in demselben Herstellungsprozeß hergestellt, so ergeben sich folgende besonders vorteilhafte Eigenschaften:

- die Schaltung benötigt lediglich eine einzige negative Betriebsspannung (SP), von z.B. -7 V;
- es ist eine weitgehende Unabhängigkeit von herstellungsbedingten Prozeßstreuungen, z.B. ± 20 %, vorhanden;
- werden zur Herstellung der Schaltung sogenannte HEMT-Prozesse angeandt, so ergibt sich ein in weiten Grenzen nahezu konstantes Temperaturverhalten der beschriebenen elektrischen Eigenschaften;
- wird eine solche Schaltung auf den erwähnten HF-Schaltungskomponenten, z.B. sogenannten MMIC-Chips (Millimeterwellen -IC), angeordnet, so ergibt sich eine sehr große Verringerung, z.B. um den Faktor 2, der ansonsten erforderlichen Ansteuerleitungen der Hochfrequenz (HF) -Komponenten, z.B. Schalter, Phasenschieber sowie Verstärker mit digitaler Verstärkungseinstellung;
- es entfallen ansonsten erforderliche Verbindungsleitungen mit den zugehörigen Verbindungsanschlüssen, z.B. sogenannte Bondanschlüsse sowie Bond-Arbeitsgänge.

Die Erfindung ist nicht die beschriebenen Ausführungsbeispiele beschränkt, sondern auf weitere anwendbar.

**Patentansprüche**

1.  Treiberschaltung zur Erzeugung einer Schaltspannung, wobei

    - ein Halbleiter-Verstärker, der ein Eingangssignal in ein Ausgangssignal umwandelt, vorhanden ist und

    - bei dem Ausgangssignal die zugehörige Ausgangsspannung durch eine Temperaturkompensierungsschaltung so geregelt wird, daß Temperaturschwankungen keinen ungewünschten Einfluß auf die Ausgangsspannung haben,
    dadurch gekennzeichnet,

    - daß mindestens drei Feldeffekt-Transistoren (A3, A4, A5) vorhanden sind, die denselben Leitungstyp besitzen und von einer aktuellen Abschnürspannung ($U_p$) gekennzeichnet sind,

- daß die aktuelle Abschnürspannung ($U_p$) gemessen wird durch eine Source-Folger-Schaltung (A5, R7 bis R10), bestehend aus dem dritten Feldeffekt-Transistor (A5),
    dessen Drain (D5) an einen Pol (M) einer Spannungsquelle (SP) angeschlossen ist,
    dessen Source (S5) mit einem End-Anschluß eines ohmschen Source-Spannungsteiler (R7, R8) verbunden ist, wobei der andere End-Anschluß des Source-Spannungsteilers (R7, R8) an den anderen Pol (-) der Spannungsquelle (SP) angeschlossen ist, und
    dessen Gate (G5) an den Mittel-Anschluß eines ohmschen Gate-Spannungsteiler (R9, R10) angeschlossen ist, dessen End-Anschlüsse an die Pole (-, M) der Spannungsquelle (SP) angeschlossen sind und der an dem Gate (G5) eine der nominellen Abschnürspannung der Feldeffekt-Transistoren (A3, A4, A5) entsprechende Spannung erzeugt,

- daß der erste Feldeffekt-Transistor (A3) mit Source (S3) an dem Mittel-Anschluß des Source-Spannungsteiler (R7, R8) angeschlossen ist derart, daß an Source (S3) des ersten Feldeffekt-Transistors (A3) eine der aktuellen Abschnürspannung entsprechende Source-Spannung ($U_{s3}$) entsteht,
    mit Drain (D3) über den als nichtlinearen Widerstand geschalteten zweiten Feldeffekt-Transistor (A4), dessen Gate (G4) und dessen Source (S4) verbunden und an Drain (D3) des ersten Feldeffekt-Transistors (A3) angeschlossen sind, an dem einen Pol (M) der Spannungsquelle (SP) liegt und
    mit Gate (G3) über einen ohmschen Widerstand (R3) an den anderen Pol (-) der Spannungsquelle (SP) angeschlossen ist und an Gate (G3) über einen weiteren ohmschen Widerstand (R2) zusätzlich das Eingangssignal (U2) anschließbar ist und die ohmschen Widerstände (R2, R3) einen Eingangsteiler für das Eingangssignal (U2) bilden,

- daß Drain (D3) des ersten Feldeffekt-Transistors (A3) mit einen Anschluß (P2) verbunden ist, an welchem, bezogen auf den einen Pols (M) der Spannungsquelle (SP), das Ausgangssignal ($U_{s1}$) abgreifbar ist.

2.  Treiberschaltung nach Anspruch 1, dadurch gekennzeichnet, daß bei den ersten und den dritten Feldeffekt-Transistoren (A3, A5) die zugehörigen Sättigungsströme ($I_{dss}$) wesentlich größer sind als der Sättigungsstrom des zweiten Feldeffekt-Transistors (A4).

3.  Treiberschaltung nach Anspruch 1 oder Anspruch 2, dadurch gekennzeichnet, daß zusätzliche eine Inverterstufe (A6 bis A8, R11, R12) vorhanden ist, deren Eingang (G6) mit dem nichtinvertierenden Ausgang (P2) verbunden ist und an deren invertierenden Ausgang (P3) ein bezüglich des Ausgangssignales ($U_{s1}$) invertiertes Ausgangssignal ($U_{s2}$) abgreifbar ist.

4. Treiberschaltung nach einem der vorhergehenden Ansprüche, dadurch gekennzeichnet, daß die Inverterstufe mit dem Source-Spannungsteiler (R7, R8) verbunden ist und entsprechend der dort gemessenen Abschnürspannung ($U_p$) gesteuert wird.

5. Treiberschaltung nach einem der vorhergehenden Ansprüche, dadurch gekennzeichnet, daß dem ohmschen Eingangsteiler (R2, R3) ein Pegelwandler, welcher eine Konstantstromquelle (A1, A2) enthält, vorgeschaltet ist.

6. Treiberschaltung nach einem der vohergehenden Ansprüche, dadurch gekennzeichnet, daß lediglich eine einzige Spannungsquelle (SP) vorhanden ist.

7. Treiberschaltung nach einem der vorhergehenden Ansprüche, dadurch gekennzeichnet, daß die verwendeten Feldeffekt-Transistoren (A1 bis A8) denselben Leitungstyp besitzen und in demselben Herstellungsprozeß hergestellt sind und dadurch diese kennzeichnende Herstellungstoleranzen haben.

**Claims**

1. Drive circuit for producing a switching voltage, wherein

   - a semiconductor amplifier, which converts an input signal into an output signal, is present and
   - for the output signal the associated output voltage is so regulated by a temperature-compensating circuit that temperature fluctuations have no undesired influence on the output voltage, characterised in that
   - at least three field effect transistors (A3, A4, A5) are present which have the same conductance type and are characterised by an actual cut-off voltage ($U_p$),
   - the actual cut-off voltage ($U_p$) is measured by a source-follower circuit (A5, R7 to R10), consisting of the third field effect transistor (A5), the drain (D5) of which is connected to one pole (M) of a voltage source (SP), the voltage source (S5) of which is connected with an end terminal of a resistive source voltage divider (R7, R8), wherein the other end terminal of the source voltage divider (R7, R8) is connected to the other pole (-) of the voltage source (SP) and the gate (G5) of which is connected to the centre terminal of a resistive gate voltage divider (R9, R10), the end terminals of which are connected to the poles (-, M) of the voltage source (SP) and which produces at the gate (G5) a voltage corresponding with the nominal cut-off voltage of the field effect transistors (A3, A4, A5),
   - the first field effect transistor (A3) is connected by source (S3) with the centre terminal of the source voltage divider (R7, R8) in such a manner that a source voltage ($U_{s3}$) corresponding with the actual cut-off voltage arises at source (S3) of the first field effect transistor (A3), lies by drain (D3) at the one pole (M) of the voltage source (SP) by way of the second field effect transistor (A4), which is connected as a non-linear resistance and the gate (G4) and source (S4) of which are connected with one another and with the drain (D3) of the first field effect transistor (A3), and is connected by gate (G3) with the other pole (-) of the voltage source (SP) by way of a resistive impedance (R3), the input signal (U2) being additionally connectible with the gate (G3) by way of a further resistive impedance (R2) and the resistive impedances (R2, R3) forming an input divider for the input signal (U2), and
   - drain (D3) of the first field effect transistor (A3) is connected with a terminal (P2), at which, referred to the one pole (M) of the voltage source (SP), the output signal ($U_{s1}$) can be tapped.

2. Driver circuit according to claim 1, characterised in that the associated saturation currents ($I_{dss}$) for the first and the third field effect transistors (A3, A5) are substantially greater than the saturation current of the second field effect transistor (A4).

3. Driver circuit according to claim 1 or claim 2, characterised in that in addition an inverter stage (A6 to A8, R11, R12) is present, the input (G6) of which is connected with the non-inverting output (P2) and at the inverting output (P3) of which an output signal ($U_{s2}$), which is inverted with respect to the output signal ($U_{s1}$), can be tapped.

4. Driver circuit according to one of the preceding claims, characterised in that the inverter stage is connected with the source voltage divider (R7, R8) and is controlled in correspondence with the cut-off voltage ($U_p$) measured there.

**5.** Driver circuit according to one of the preceding claims, characterised in that a level converter, which includes a constant current source (A1, A2), is connected upstream of the resistive input divider (R2, R3).

**6.** Driver circuit according to one of the preceding claims, characterised in that merely a single voltage source (SP) is present.

**7.** Driver circuit according to one of the preceding claims, characterised in that the field effect transistors (A1 to A8) used have the same conductance type and are produced in the same manufacturing process and thereby have production tolerances characterising this.

**Revendications**

**1.** Circuit d'attaque en vue de la génération d'une tension de commutation comprenant

- un amplificateur à semiconducteur, qui convertit un signal d'entrée en un signal de sortie et
- dans lequel signal de sortie la tension de sortie associée est régulée par un circuit de compensation de température, des fluctuations de températures n'ayant aucune influence contraire sur la tension de sortie, caractérisé en ce que
- au moins trois transistors à effet de champ (A3, A4, A5) sont prévus, qui possèdent le même type de conductivité et sont caractérisés par une tension d'étranglement réelle ($U_p$),
- en ce que la tension d'étranglement réelle ($U_p$) est mesurée par un circuit à source asservie (A5, R7 à R10), se composant du troisième transistor à effet de champ (A5),

  dont le drain (D5) est relié à un pôle (M) d'une source de tension (SP),

  dont la source (S5) est reliée à une borne d'extrémité d'un diviseur de tension de source ohmique (R7, R8), l'autre borne d'extrémité du diviseur de tension de source (R7, R8) étant reliée à l'autre pôle (-) de la source de tension (SP), et

  dont la grille (G5) est reliée à la borne médiane d'un diviseur de tension de grille ohmique (R9, R10), dont les bornes d'extrémité sont reliées aux pôles (-, M) de la source de tension (SP) et qui génère sur la grille (G5) une tension correspondant à la tension d'étranglement nominale des transistors à effet de champ (A3, A4, A5),

- en ce que le premier transistor à effet de champ (A3) est relié par la source (S3) à la borne médiane du diviseur de tension de source (R7, R8) de telle sorte que sur la source (S3) du premier transistor à effet de champ (A3) apparaisse une source de tension ($U_{s3}$) correspondant à la tension d'étranglement réelle,

est relié par le drain (D3) par l'intermédiaire du second transistor à effet de champ (A4) monté en résistance non linéaire, dont la grille (G4) et dont la source (S4) sont réunies et reliées au drain (D3) du premier transistor à effet de champ (A3), à un pôle (M) de la source de tension (SP) et

est relié par la grille (G3), par l'intermédiaire d'une résistance ohmique (R3) à l'autre pôle (-) de la source de tension (SP) et à la grille (G3), par l'intermédiaire d'une autre résistance ohmique (R2), peut être appliqué en plus le signal d'entrée (U2), et les résistances ohmiques (R2, R3) forment un diviseur d'entrée pour le signal d'entrée (U2),

- en ce que le drain (D3) du premier transistor à effet de champ (A3) est relié à une borne (P2), sur laquelle, par rapport au premier pôle (M) de la source de tension (SP), peut être prélevé le signal de sortie ($U_{s1}$).

**2.** Circuit d'attaque selon la revendication 1, caractérisé en ce que, pour les premier et troisième transistors à effet de champ (A3, A5), les courants de saturation associés ($I_{dss}$) sont sensiblement plus élevés que le courant de saturation du second transistor à effet de champ (A4).

**3.** Circuit d'attaque selon la revendication 1 ou la revendication 2, caractérisé en ce qu'en plus est prévu un étage inverseur (A6 à A8, R11-R12), dont l'entrée (G6) est reliée à la sortie sans inversion (P2) et à la sortie avec inversion (P3) de celui-ci peut être prélevé un signal de sortie ($U_{s2}$) inversé par rapport au signal de sortie ($U_{s1}$).

**4.** Circuit d'attaque selon l'une quelconque des revendications précédentes, caractérisé en ce que l'étage inverseur est relié au diviseur de tension de source (R7, R8), et est commandé de façon correspondant à la tension d'étranglement ($U_p$) mesurée sur celui-ci.

**5.** Circuit d'attaque selon l'une quelconque des revendications précédentes, caractérisé en ce qu'en amont du diviseur d'entrée ohmique (R2, R3) est disposé un convertisseur de niveau, qui contient une source de courant constant (A1, A2).

**6.** Circuit d'attaque selon l'une quelconque des revendications précédentes, caractérisé en ce qu'une unique source de tension (S) est prévue.

**7.** Circuit d'attaque selon l'une quelconque des revendications précédentes, caractérisé en ce que les transistors à effet de champ utilisés (A1 à A8) possèdent le même type de conductivité et sont réalisés selon le même processus de fabrication et présentent ainsi ces tolérances de fabrication caractérisantes.

Fig. 1

Fig. 2

Fig. 3